Europäisches Patentamt

European Patent Office

Office européen des brevets

(11) Publication number: **0 283 587 B1**

(12) **EUROPEAN PATENT SPECIFICATION**

(45) Date of publication of patent specification: **07.10.92** (51) Int. Cl.5: **H01L 23/48**, C22C 9/00

(21) Application number: **87119153.2**

(22) Date of filing: **23.12.87**

The file contains technical information submitted after the application was filed and not included in this specification

(54) **Bonding wire.**

(30) Priority: **27.02.87 JP 44744/87**

(43) Date of publication of application:
**28.09.88 Bulletin 88/39**

(45) Publication of the grant of the patent:
**07.10.92 Bulletin 92/41**

(84) Designated Contracting States:
**DE FR GB**

(56) References cited:
**DE-A- 3 610 582
GB-A- 2 175 009**

**PATENT ABSTRACTS OF JAPAN, vol. 11, no. 99 (E-493)[2546], 27th March 1987; & JP - A - 61 251 062 (NIPPON MINING CO. LTD.) 08-11-1986 (Cat. A)**

**PATENT ABSTRACTS OF JAPAN, vol. 11, no. 110 (E-496)[2557], 7th April 1987; & JP - A - 61 258 463 (MITSUBISHI) 15-11-1986 (Cat. A)**

**PATENT ABSTRACTS OF JAPAN, vol. 9, no. 284 (E-357)[2007], 12th November 1985; & JP - A - 60 124 959 (SUMITOMO) 04-07-1985**

(73) Proprietor: **TATSUTA ELECTRIC WIRE & CABLE CO., LTD**
**3-1, Iwatacho 2-chome Higashiosaka-shi Osaka 578(JP)**

(72) Inventor: **Tokida, Masanori**
**9-12-102, 5-chome, Ukyo**
**Nara City Nara(JP)**
Inventor: **Mori, Kenji**
**2118-8, Komyo-cho**
**Ikoma City Nara(JP)**
Inventor: **Fukuda, Takanori**
**6-3-314, Tezukayama**
**Nara City Nara(JP)**
Inventor: **Fujimoto, Eiichi**
**1-12-25, Hishiyahigashi**
**Higashiosaka City Osaka(JP)**
Inventor: **Ohtaki, Toshitake**
**9-3-2, Minamidaira**
**Hino City Tokyo(JP)**

(74) Representative: **Strehl, Schübel-Hopf, Groening**
**Maximilianstrasse 54 Postfach 22 14 55**
**W-8000 München 22(DE)**

PATENT ABSTRACTS OF JAPAN, vol. 11, no. 81 (E-488)[2528], 12th March 1987; & JP - A - 61 234 063 (TANAKA DENSHI) 18-10-1986 (Cat. A)

SOLID STATE TECHNOLOGY, March 1980, pages 84-91, New York, US; B. GEHMANN "Gold wire for automated bonding"

## Description

### a. Field of the Art

The present invention relates to bonding wires for connecting semiconductor elements used in transistors, ICs, LSIs and the like to external leads, and more particularly to bonding wires for semiconductor elements which form copper balls having suitable hardness at the time of connection.

### b. Prior Art

There are known fine wires of pure gold or an aluminium alloy containing 1% of Si, as bonding wires for connecting electrodes on silicon semiconductor elements to external leads. Of these, gold fine wires are widely used in view of their properties of reliable connection and resistance to corrosion. More specifically, when gold fine wires are used at the time of connection by a thermocompression bonding method, gold balls having suitable hardness are formed for connection. Accordingly, the pressure exerted at the time of bonding does not cause damages to silicon semiconductor elements. This results in considerable reduction in troubles due to defective connection in semiconductor products.

However, such gold fine wires are very expensive and have small breaking strength, often causing the wires to be disconnected when automatically connected at a high speed.

In view of the foregoing, there have been proposed bonding wires made of copper having a purity equal to or more than 99.99% by weight, as more economical bonding wires capable of forming balls having suitable hardness, and having greater breaking strength than that of gold fine wires (Japanese Laid-Open Patent Publications 60-124959, 62-2645 and 62-22469).

However, the highly pure copper constituting such bonding wires contains impurities such as silver, silicon, bismuth, iron, nickel, tin, sulfur, phosphorus, lead, oxygen and the like, which may exert a great influence on the hardness of copper balls. Accordingly, when such bonding wires are connected to semiconductor elements, copper balls formed may be hard to cause damages to the semiconductor elements compression-bonded by such copper balls.

GB-A-2 175 009 shows a bonding wire containing 0.5 - 3 ppm of at least one component selected from a rare earth element and Y, the balance being Cu and incidental impurities including no more than 0.2 ppm of 5 and 0.1 ppm of Se or Te, the total content of incidental impurities not exceeding 1 ppm.

### Objects of the Invention

It is an object of the present invention to provide bonding wires made of copper having a purity equal to or more than 99.99% by weight which can form copper balls having hardness similar to that of gold balls which are suitable for connection with semiconductor elements.

### Summary of the Invention

The object above-mentioned of the present invention may be achieved by providing a bonding wire made of copper in which the contents of peculiar impurity elements exerting a great influence upon the hardness of copper balls are reduced to predetermined amounts or less.

The bonding wire in accordance with the present invention is made of copper having a purity equal to or more than 99.99% by weight, in which the content of any element selected from a first impurity element group consisting of silver and silicon is 5 ppm or less, the content of any element selected from a second impurity element group consisting of bismuth, iron, nickel, tin, sulfur, phosphorus and lead is 1 ppm or less, the content of a third impurity or oxygen is 5 ppm or less, and the sum total of all the contents of elements selected from the first, second and third impurity element groups is 10 ppm or less, excluding the range 1 ppm or less.

The bonding wire in accordance with the present invention has greater breaking strength than that of a gold fine wire.

### Detailed Description of the Preferred Embodiments

The bonding wire in accordance with the present invention is made of copper having a purity equal to or more than 99.99% by weight containing, in predetermined amounts or less, impurities such as silver, silicon, bismuth, iron, nickel, tin, sulfur, phosphorus, lead and oxygen, which exert a great influence upon the hardness of copper balls.

Based on different-type influences exerted upon the hardness of copper balls formed, these impurities are divided into three groups; a first impurity element group consisting of silver and silicon, a second impurity element group consistiting of bismuth, iron, nickel, tin, sulfur, phosphorus and lead and a third impurity element group consisting of oxygen. It is required that the content of any element selected from each of these impurity element groups be a predetermined amount or less, and that the sum total of all the contents of the impurities be also a predetermined amount or less. Unless these requirements are satisfied, the copper balls formed may be hard and consequently unsuitable for connection with semiconductor elements.

More specifically, the following cases may be actually considered:

1) When the content of any element selected from the first impurity element group is 5 ppm or less, and the sum total of the contents of elements selected from the first and second impurity element groups and the content of oxygen is 10 ppm or less;

(1) If the content of oxygen is 5 ppm or more even though the content of any element selected from the second impurity element group is 1 ppm or less, the hardness of cooper balls becomes improper due to the influence by the oxygen.

(2) If the content of at least one element selected from the second impurity element group is 1 ppm or more even though the content of oxygen is 5 ppm or less, the hardness of copper balls becomes improper due to the influence by the element of the second impurity element group.

(3) If the content of oxygen is 5 ppm or more and the content of at least one element selected from the second impurity element group is 1 ppm or more, the hardness of copper balls becomes improper due to the influence by the oxygen and the element of the second impurity element group.

2) If the content of at least one element selected from the first impurity element group is 5 ppm or more, and the sum total of the contents of elements selected from the first and second impurity element groups and the content of oxygen is 10 ppm or less even though the content of oxygen is 5 ppm or less and the content of any element selected from the second impurity element group is 1 ppm or less, the hardness of copper balls becomes improper due to the influence by the element of the first impurity element group.

The bonding wire in accordance with the present invention is made of copper containing, in predetermined amounts or less, peculiar impurities which exert a great influence upon the hardness of copper balls. Copper balls formed from the bonding wire of the present invention have hardness similar to that of gold balls formed from a conventional gold fine wire. Accordingly, the bonding wire of the present invention causes no damages to silicon semiconductor elements when connected. Further, the bonding wire of the present invention is more economical than a gold fine wire, and has greater breaking strength in the same diameter than that of a gold fine wire. This enables the bonding wire to be connected with the use of a high-speed automatic bonder, thus providing great utility.

The following description will discuss in more detail examples of the present invention with reference to comparative examples, but it should be understood that the present invention is not limited to such examples.

Invention Examples 1 to 4

Oxygen-free copper used as a raw material was repeatedly refined by means of an electrolytic process or a zone melting process, and then subjected to a vacuum-fusion process to obtain a copper ingot having a composition shown in Table 1. The ingot was ground at the surface thereof by 8% and then subjected to a rolling and drawing processes at an ambient temperature to produce copper fine wires having a final diameter of 25 $\mu$m. The wires thus produced were continuously annealed in an atmosphere of inert gas such that the extensibility of 10% is achieved for the copper fine wires. Thus, bonding wires were produced. With a high-speed automatic bonder, such bonding wires were once connected to electrodes of bipolar ICs. Afterwards, the bonding wires and the aluminium electrodes on the silicon oxide layers were etched and removed with an acid. The semi-conductor elements comprising silicon oxide layers and silicon semiconductors were checked for damages with a microscope. The results are also shown in Table 1.

Comparative Examples 1 to 10

Copper having a high purity of 99.9999 % by weight and all elements of the first and second impurity element groups were put in a cylindrical graphite melting pot having an inner diameter of 27 mm and a length of 300 mm, and molten in a vacuum high-frequency melting furnace while the degree of vacuum was being adjusted. Afterwards, the molten copper was cooled and solidified in the graphite melting pot to obtain a copper ingot having a composition shown in Table 1.

Likewise the Invention Examples, this copper ingot was prepared to produce bonding wires

Likewise the Invention Examples, the bonding wires thus produced were connected to semiconductor elements, after which the semiconductor elements were checked for damages. The results are also shown in Table 1.

Table 1

| Impurities | No | Invention Examples 1 | Invention Examples 2 | Invention Examples 3 | Invention Examples 4 | Comparative Examples 1 | Comparative Examples 2 | Comparative Examples 3 | Comparative Examples 4 | Comparative Examples 5 | Comparative Examples 6 | Comparative Examples 7 | Comparative Examples 8 | Comparative Examples 9 | Comparative Examples 10 |
|---|---|---|---|---|---|---|---|---|---|---|---|---|---|---|---|
| Purity of Copper (% by weight) | | 99.999 | 99.999 | 99.999 | 99.999 | 99.999 | 99.999 | 99.998 | 99.999 | 99.999 | 99.999 | 99.998 | 99.999 | 99.999 | 99.999 |
| First impurity elements (ppm) | Ag | 4 | 0.2 | 0.1 | 0.3 | 0.5 | 0.3 | 3 | 4 | 0.1 | 0.1 | 0.1 | 0.1 | 6 | 0.2 |
| Second impurity elements (ppm) | Si | 0.1 | 4 | 0.2 | 0.5 | 0.3 | 0.3 | 1 | 0.2 | 0.2 | 0.2 | 0.2 | 0.2 | 0.1 | 7 |
| | S | 0.5 | 0.5 | 3 | 0.5 | 0.5 | 0.5 | 0.5 | 0.5 | 0.5 | 0.5 | 0.5 | 0.5 | 0.5 | 0.5 |
| | Bi | 0.05 | 0.05 | 0.05 | 0.05 | 1.5 | 0.05 | 0.5 | 0.05 | 0.05 | 0.05 | 0.05 | 0.05 | 0.05 | 0.05 |
| | Fe | 0.02 | 0.02 | 0.02 | 0.02 | 0.2 | 2.0 | 0.5 | 0.02 | 0.02 | 0.02 | 0.02 | 0.02 | 0.02 | 0.02 |
| | Ni | 0.03 | 0.03 | 0.03 | 0.03 | 0.03 | 0.03 | 0.3 | 1.3 | 0.03 | 0.03 | 0.03 | 0.03 | 0.03 | 0.03 |
| | Sn | 0.05 | 0.05 | 0.05 | 0.05 | 0.05 | 0.05 | 0.05 | 0.05 | 2.0 | 0.05 | 0.05 | 0.05 | 0.05 | 0.05 |
| | P | 0.1 | 0.1 | 0.1 | 0.1 | 0.1 | 0.1 | 0.1 | 0.1 | 0.1 | 1.6 | 0.1 | 0.1 | 0.1 | 0.1 |
| | Pb | 0.2 | 0.2 | 0.2 | 0.2 | 0.2 | 0.2 | 0.2 | 0.2 | 0.2 | 0.2 | 0.2 | 1.8 | 0.2 | 0.2 |
| Third impurity (ppm) | $O_2$ | 2 | 3 | 2 | 4 | 3 | 3 | 2 | 2 | 2 | 2 | 10 | 3 | 2 | 1 |
| Sum total of first, second and third impurities (ppm) | | 7.05 | 8.15 | 5.75 | 5.75 | 6.38 | 6.53 | 11.65 | 8.42 | 5.20 | 4.75 | 11.25 | 5.85 | 9.05 | 9.15 |
| Damage of Si Semiconductor | | Absent | Absent | Absent | Absent | Absent | Absent | Present | Present | Absent | Absent | Present | Absent | Present | Present |
| Damage of Si Oxide Layer | | Absent | Absent | Absent | Absent | Present | Present | Present | Present | Present | Present | Present | Present | Present | Present |

As to the columns of Damage of Si Semiconductor and Damage of Si Oxide Layer in Table 1, Invention Examples and Comparative Examples in which cracks were observed and were not observed, are represented by "Present" and "Absent", respectively.

As apparent from Table 1, in the bonding wires of Invention Examples 1 to 4, the content of any element selected from the first impurity element group, the content of any element selected from the second impurity element group and the content of oxygen are respective predetermined amounts or less, and the sum total of all the contents above-mentioned is a predetermined amount or less. Accordingly, the hardness of copper balls formed at the time of connection is suitable, resulting in no damages to the semiconductor elements.

In the bonding wires of Comparative Examples 1, 2, 3, 4, 5, 6 and 8, the content of an element selected from the second impurity element group is 1 ppm or more. Therefore, copper balls formed at the time of connection are hard to cause damages to semiconductor elements.

The bonding wire of Comparative Example 7 contains a great content of oxygen, although the content of any element selected from the first and second impurity groups is a predetermined amount or less. Accordingly, copper balls formed at the time of connection are hard to cause damages to semiconductor elements.

In the bonding wires of Comparative Examples 9 and 10, the content of an element selected from the first impurity element group is high although the content of any element selected from the second impurity element group and the content of oxygen are respective predetermined amounts or less. Accordingly, copper balls formed at the time of connection are hard to cause damages to semiconductor elements.

## Claims

1.  A bonding wire made of copper having a purity equal to or more than 99.99 % by weight in which:

    the content of any element selected from a first impurity element group consisting of silver and silicon is 5 ppm or less;

    the content of any element selected from a second impurity element group consisting of bismuth, iron, nickel, tin, sulfur, phosphorus and lead is 1 ppm or less;

    the content of a third impurity or oxygen is 5 ppm or less; and

    the sum total of all the contents of elements selected from said first,second and third impurity element groups is 10 ppm or less, excluding the range 1 ppm or less.

## Patentansprüche

1.  Bonddraht aus Kupfer mit einer Reinheit gleich oder größer als 99,99 Gew.-%, wobei

    der Gehalt jedes Elements aus einer aus Silber und Silizium bestehenden ersten Störstoffgruppe 5 ppm oder geringer ist,

    der Gehalt jedes Elements aus einer aus Wismut, Eisen, Nickel, Zinn, Schwefel, Phosphor und Blei bestehenden zweiten Störstoffgruppe 1 ppm oder geringer ist,

    der Gehalt eines dritten Störstoffs oder Sauerstoff 5 ppm oder geringer ist, und

    die Summe sämtlicher aus der ersten, der zweiten und der dritten Störstoffgruppe ausgewählten Elemente 10 ppm oder kleiner ist, jedoch nicht im Bereich von 1 ppm oder kleiner liegt.

## Revendications

1.  Fil de connexion réalisé en cuivre possédant une pureté égale ou supérieure à 99,99% en poids, dans lequel :

    la teneur d'un élément quelconque choisi parmi un premier groupe d'éléments d'impuretés constitué d'argent et de silicium est 5 ppm ou moins ;

    la teneur d'un élément quelconque choisi parmi un second groupe d'éléments d'impuretés constitué de bismuth, de fer, de nickel, d'étain, de soufre, de phosphore et de plomb est 1 ppm ou moins ;

    la teneur d'une troisième impureté ou d'oxygène est 5 ppm ou moins ; et

    la somme totale de toutes les teneurs d'éléments choisis parmi lesdits premier, second et troisième groupes d'éléments d'impuretés est 10 ppm ou moins, à l'exclusion de la plage 1 ppm ou moins.